# EUROPÄISCHE PATENTSCHRIFT

(11) **EP 0 593 986 B1**
(45) Veröffentlichungstag und Bekanntmachung des Hinweises auf die Patenterteilung: **04.06.1997**
(21) Anmeldenummer: 93116235.8
(22) Anmeldetag: 07.10.1993
(51) Int. Cl.: H01L 21/60, H01L 21/607

(54) **Verfahren zum Verlöten eines Halbleiterkörpers mit einem Trägerelement**
Process of soldering a semiconductor body to a supportelement
Procédé de soudage d'un corps semi-conducteur à un élément de support

(30) Priorität: 23.10.1992 DE 4235908
(43) Veröffentlichungstag der Anmeldung: 27.04.1994
(73) Patentinhaber: TEMIC TELEFUNKEN microelectronic GmbH, 74072 Heilbronn (DE)
(72) Erfinder: Strohmüller, Franz, A-5280 Braunau (AT)
(74) Vertreter: Maute, Hans-Jürgen, Dipl.-Ing.

(56) Entgegenhaltungen:
- EP-A- 0 163 163
- EP-A- 0 182 184
- EP-A- 0 186 829
- DE-A- 2 032 939
- DE-A- 2 814 642
- DE-A- 3 110 080

## Beschreibung

Die Erfindung betrifft ein Verfahren zum Auflöten eines scheibenförmigen Halbleiterkörpers auf ein Trägerelement nach dem Oberbegriff des Anspruchs 1.

Ein derartiges Verfahren ist beispielsweise aus der DE-OS 1 903 274 bekannt. Bei dem bekannten Verfahren wird zuerst ein Träger mit einer Lotschicht versehen und dann der Halbleiterkörper auf den beschichteten Träger aufgelegt und mit diesem verlötet. Die Lotschicht wird durch Auflegen einer Lotfolie auf den Träger hergestellt. Die Lotfolie wird im Lötofen auf den Träger aufgeschmolzen. Dabei bildet sich die Lotschicht kalottenförmig aus. Anschließend wird der Halbleiterkörper auf die Lotschicht aufgelegt. Im folgenden Lötprozeß muß nun der Halbleiterkörper entweder mittels einer Schablone oder mittels einer in die Lotschicht eingeprägten Orientierungsgrube in Position gehalten werden, damit er nicht auf dem schmelzenden Lot verschwimmt. Dieses bekannte Verfahren weist jedoch die Nachteile auf, daß die Dicke der Lotschicht stark begrenzt ist, da es zu einem seitlichen Lotauslauf kommt und daß die Dicke der Lotschicht zwischen einzelnen Bauelementen stark variiert. Zudem ist mit dem Verfahren ein großer manueller Justieraufwand verbunden.

Aus der EP-A 0 186 826 ist ein Lötverfahren bekannt, bei dem in den Fügebereich ein mehrschichtiger Verbundwerkstoff zwischen dem Halbleiterelement und dem metallischen Träger angeordnet ist. Das eigentliche Verlöten erfolgt duch Erhitzen der Anordnung auf eine Temperatur von 180 °C bis 350 °C, wobei ggf. zusätzlich eine Druckkraft auf Halbleiterelement und Träger ausgeübt wird.

Aus der DE-A 31 10 080 ist ein Verfahren zum Verbinden eines Halbleiterkörpers mit einem metallischen Träger bekannt, bei dem der Halbleiterkörper mit einer Goldschicht und der Träger mit einer Schicht einer Kupferlegierung versehen wird. Zum Verbinden werden sowohl der Halbleiterkörper als auch der Träger auf eine Temperatur zwischen 430 °C und 480 °C erhitzt und durch eine Nadel, die den Halbleiterkörper auf den Träger aufdrückt, in Schwingungen parallel zur Ebene der Verbindungsfläche der Frequenz zwischen 30 Hz und 100 Hz versetzt.

Bei einem weiteren, aus der EP-PS 149 232 bekannten Verfahren wird eine verlorene Lötschablone auf den Träger aufgesetzt. Die Lötschablone weist eine erste Aussparung auf, in die der scheibenförmige Halbleiterkörper eingelegt wird. In weiteren Aussparungen der verlorenen Lötschablone werden Lotformteile eingelegt und die so montierte Anordnung durch einen Lötofen transportiert. Beim Lötprozeß wird das in die weiteren Aussparungen der Lötschablone eingebrachte Lot geschmolzen und wandert unter die Lötschablone und unter den scheibenförmigen Halbleiterkörper. Lötschablone und Halbleiterkörper werden dadurch gleichzeitig auf den metallischen Träger aufgelötet. Dieses Verfahren weist den Nachteil auf, daß die Dicke der erzielbaren Lotschicht zwischen Halbleiterkörper und Träger durch seitlich auslaufendes Lot begrenzt ist. Auch dieses Verfahren weist den Nachteil auf, daß die Dicke der Lotschicht zwischen den einzelnen Bauelementen stark variiert. Weiterhin sind die auf diese Art hergestellten Bauelemente wegen der starken Lunkerbildung und wegen der nur dünnen Lotschicht thermisch nicht stark belastbar. Auch bei diesem Verfahren ist ein großer Aufwand bei der manuellen Justierung erforderlich.

Aufgabe der Erfindung ist es, ein Verfahren zum Auflöten eines Halbleiterkörpers auf einen Träger anzugeben, das automatisiert werden kann und das Herstellen von Lotschichten großer Dicken und guter Reproduzierbarkeit ermöglicht.

Diese Aufgabe wird durch die Verfahren mit den kennzeichnenden Merkmalen der Ansprüche 1 und 8 gelöst. Die vorteilhafte Ausgestaltung der Verfahren erfolgt gemäß den Merkmalen der abhängigen Ansprüche.

Es ist ein wesentlicher Bestandteil der Erfindung, daß Lotformteil 2 und Halbleiterkörper 3 nacheinander auf den Träger 1 aufgelegt werden und die so erhaltene Anordnung in einem einzigen Ofenprozeßschritt verlötet wird. Die Anordnung wird vor dem Ofenprozeßschritt justiert und fixiert, indem der Halbleiterkörper 3 durch eine Reibebewegung, einem sogenannten Scrub, unter Krafteinwirkung in Normalen-Richtung auf das Lotformteil 2 aufgelegt wird. Beim Scrub entstehen punktuelle Verbindungen zwischen dem Halbleiterkörper 3 und dem Lotformteil 2, die die Anordnung bis zum Verlöten fixieren. Im sich anschließenden Ofenprozeßschritt schmilzt das Lotformteil 2 auf und bildet eine gleichmäßig dicke Lotschicht zwischen Halbleiterkörper 3 und Träger 1. Kohäsions- und Kapillarkräfte ziehen das geschmolzene Lot unter den Halbleiterkörper 3 und verhindern das seitliche Auslaufen des Lotes. Sämtliche Verfahrensschritte lassen sich auf einfache Weise automatisieren, so daß die manuelle Bestückung und Justage entfallen kann. Durch die Wahl der Dicke des Lotformteils 2 lassen sich selbst Lötverbindungen großer Stärke mit guter Reproduzierbarkeit herstellen. Durch die geringe Lunkerbildung sind die erzielten Lotverbindungen thermisch stark belastbar.

Das Auflegen des Lotformteils 2 auf den Träger 1 erfolgt vorteilhaft bei einer ersten, erhöhten Temperatur. Diese Temperatur liegt unterhalb des Liquiduspunktes des verwendeten Lotes. Es hat sich als besonders vorteilhaft herausgestellt, bei einem nicht-eutektischen Lot die Temperatur beim Auflegen des Lotformteils auf den Träger so einzustellen, daß sie zwischen dem Solidus- und dem Liquiduspunkt des verwendeten Lotes liegt. In diesem Temperaturbereich ist das Lotformteil leicht plastisch verformbar und es schmiegt sich beim Auflegen an den Träger an und haftet gut auf diesem. In dem gewählten Temperaturbereich schmilzt das Lot noch nicht.

Danach kann das Lotformteil 2 mittels eines Flachstempels planiert werden.

Wird das Lot nicht in Form eines Lotformteils, sondern durch Abschmelzen einer Lotlinse von einem Lotdraht auf den Träger aufgebracht, so befindet sich der Träger vorteilhaft auf einer Temperatur, die größer ist als die Schmelztemperatur des verwendeten Lots. Zum Auflegen des Halbleiterkörpers wird der Träger wieder abgekühlt.

Die Temperatur, bei der der Halbleiterkörper 3 auf das Lotformteil 2 aufgelegt wird, ist vorteilhaft kleiner als die Temperatur beim Auflegen des Lotformteils. Dies gilt insbesondere dann, wenn die Temperatur beim Auflegen des Lotformteils größer war als die Solidustemperatur des Lotes.

Anstelle des Belegens des Trägers 1 mit einem Lotformteil, kann es auch vorgesehen sein, durch Abschmelzen von drahtförmigem Lot auf einem über die Schmelztemperatur des verwendeten Lots erwärmten Träger eine Lotschicht zu erzeugen. Dabei bildet sich eine linsenförmige Schicht aus. Anschließend wird der Träger mit der linsenförmigen Lotschicht auf die zweite Temperatur abgekühlt, die kleiner ist als der Soliduspunkt des verwendeten Lotes.

Die Andruckkraft des Halbleiterkörpers 3 beim Scrub (bei der Reibebewegung) liegt typischerweise zwischen 20 und 100 mN. Die Reibebewegung weist typischerweise eine Frequenz von 5 bis 10 Hz auf. Die Amplitude ihrer Auslenkung liegt im Bereich von ca. 10 µm. Die genaue Abstimmung dieser Parameter erfolgt anhand von Versuchen und wird durch das Haftverhalten des Halbleiterkörpers auf dem Lotformteil bestimmt.

Zur Vermeidung von Oxidationsprozessen erfolgt das Auflegen des Lotformteils 2 bzw. das Aufschmelzen der Lotlinse und das Auflegen des Halbleiterkörpers 3 in der Gegenwart einer Schutzgasatmosphäre.

In einer vorteilhaften Ausgestaltung des Verfahrens wird der Halbleiterkörper 3 mit dem Träger 1 in einem Vakuumofen verlötet.

In einer anderen Ausgestaltung des Verfahrens erfolgt der Verfahrensschritt des Verlötens in einer reduzierenden Atmosphäre.

Es hat sich weiterhin als besonders vorteilhaft herausgestellt, wenn die flächenmäßigen Abmessungen des Lotformteils 2 bzw. der Lotlinse denen des Halbleiterkörpers 3 entsprechen bzw. etwas kleiner als diese sind. Dann nämlich können auch extrem dicke Lotverbindungen hergestellt werden, ohne daß es zu merklichem, seitlichem Lotaustritt zwischen Halbleiterkörper 3 und Trägerelement 1 kommt.

Weiterhin kann über die Flächenverhältnisse des Halbleiterkörpers 3 und des Lotformteils 2 bzw. der Lotlinse jede beliebige Dicke der Lotverbindung eingestellt werden, da sich das Lotvolumen gleichmäßig unter der Fläche des Halbleiterkörpers 3 verteilt.

In einer Weiterbildung der Erfindung weist der Träger 1 im Bereich, in dem der Halbleiterkörper 3 plaziert wird, eine Riffelung 5 auf. Die Riffelung 5 sorgt für eine gleichmäßige Entlüftung zwischen Träger 1 und Lot beim Ofenprozeßschritt. Beim Löten in einer reduzierenden Atmosphäre kann das Prozeßgas durch die Kanäle der Riffelung 5 hindurchströmen.

Im folgenden sei das erfindungsgemäße Verfahren anhand eines Ausführungsbeispiels erläutert. Es zeigen die
- Figur 1: ein nach dem erfindungsgemäßen Verfahren hergestelltes Bauelement,
- Figur 2: das Trägerelement vor der Montage.

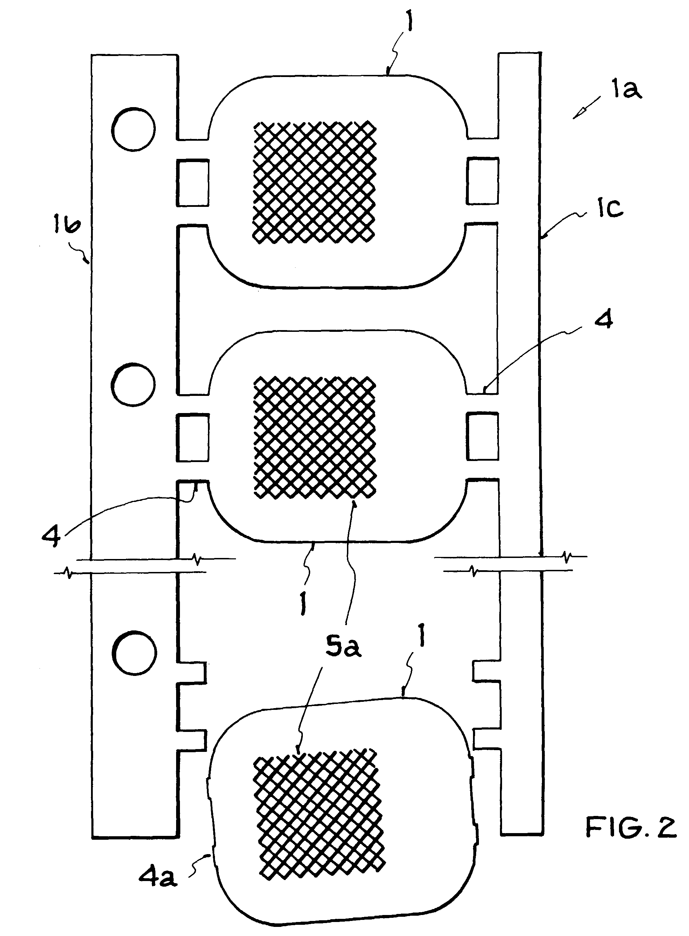

Die Figur 2 zeigt einen Trägerstreifen 1a, der für das erfindungsgemäße Verlöten mit einem scheibenförmigen Halbleiterkörper 3 vorgesehen ist. Der Trägerstreifen 1a besteht aus den eigentlichen Trägern 1, die auf zwei Seiten von je einem Längssteg 1b, 1c flankiert und mit diesen verbunden sind. Die Verbindung erfolgt durch die Verbindungsstege 4. Im unteren Teil der Figur 2 ist ein Träger 1 dargestellt, der aus dem Trägerstreifen 1a herausgetrennt wurde. An den Seiten des Trägers bleiben die Rudimente 4a der Verbindungsstege 4 zurück. Das Heraustrennen der Träger 1 erfolgt im allgemeinen erst nach dem Verlöten der Halbleiterkörper 3 mit den Trägern 1. Die Anordnung mehrerer Träger 1 zu einem Streifenelement 1a ermöglicht eine automatische Bestückung der Träger 1. Der Trägerstreifen 1a besteht aus einer Kupferlegierung und ist an der Oberfläche vernickelt. Auf der einen flachen Oberseite weist der Träger 1 in dem Bereich, auf den der Halbleiterkörper 3 gelötet wird, eine Riffelung 5 auf. Die flächenmäßige Ausdehnung der Riffelung entspricht im wesentlichen der Fläche des Halbleiterelements 3 und kann vorzugsweise etwas größer als jene sein.

In einem ersten Verfahrensschritt wird der Träger 1 auf eine Temperatur erwärmt, die unterhalb des Liquiduspunktes des verwendeten Lotes liegt. Handelt es sich bei dem Lot um eine nicht-eutektische Legierung, so liegt die Temperatur vorteilhaft zwischen dem Solidus- und dem Liquiduspunkt. Bei den verwendeten Loten liegt diese Temperatur im Bereich zwischen 290 und 296 °C. Bei dieser Temperatur wird ein Abschnitt einer Lotfolie 2 auf den Träger 1 aufgelegt und in den Bereich positioniert, in dem das Halbleiterelement montiert werden soll. Bei der angegebenen Temperatur schmilzt das Lotformteil 2, das in Form eines Folienabschnitts auf den Träger gelegt wird, noch nicht, ist aber bereits plastisch. Dadurch paßt sich die Lotfolie 2 ideal an den Träger an und haftet auf diesem. Falls nötig, kann das Lotformteil 2 auch punktuell thermogeheftet werden.

Die flächenmäßige Ausdehnung des Lotformteils 2 ist in einer vorteilhaften Ausgestaltung des Verfahrens kleiner zu wählen als die Ausdehnung des Halbleiterkörpers 3. Dadurch wird erreicht, daß selbst bei sehr dicken Lotschichten ein seitlicher Lotaustritt selbst dann nicht vorkommt, wenn die Kohäsions- und Kapillarkräfte nicht mehr ausreichen, um beim Lötvorgang das Lot unter das Element zu ziehen.

Da sich beim Verlöten das gesamte Lotvolumen des Lotformteils 2 auf die Fläche des Halbleiterelements 3 verteilt, kann durch das Verhältnis der Fläche des Lotformteils 2 zur Fläche des Halbleiterkörpers 3 eine Feineinstellung der Lotschichtdicke erfolgen. Im Ausführungsbeispiel beträgt die Dicke des Lotformteils 2 100 µm. Die Fläche entspricht genau der des Halbleiterkörpers. Vor dem Auflegen des Halbleiterkörpers 3 kann das Lotformteil 2 noch zusätzlich durch einen Flachstempel planiert werden.

Im nächsten Verfahrensschritt wird der Träger 1 auf eine Temperatur abgekühlt, die unterhalb der Solidustemperatur des Lotes liegt. Im Verfahren nach dem Ausführungsbeispiel wird um ca. 50 °C auf ca. 220 bis 230 °C abgekühlt. Bei dieser Temperatur wird der Halbleiterkörper 3 über das Lotformteil 2 auf den Träger 1 aufgelegt. Das Auflegen erfolgt mit einer Reibebewegung senkrecht zur Normalen-Richtung und mit einer kleinen Kraft in Normlen-Richtung. Der Halbleiterkörper 3 wird dabei von einem Die Collet gehalten. Die Reibebewegung, auch Scrub genannt, erfolgt im Ausführungsbeispiel mit einer Normalen-Kraft von ca. 50 mN, einer Frequenz von 5 bis 10 Hz und einer Amplitude von ca. 10 µm. Bei dieser Scrub-Bewegung entstehen durch lokale Erwärmungen des Lotes 2 und des Halbleiterkörpers 3 punktuelle Verbindungen zwischen diesen. Die Verbindungen fixieren den Halbleiterkörper 3 auf dem Trägerstreifen 1, so daß z. B. beim nachfolgenden Transport in den Lötofen die Anordnung erhalten bleibt.

Es ist selbstverständlich, daß das Auflegen von Lotformteil 2 und Halbleiterkörper 3 mit einer Präzision erfolgen muß, die ein automatisches Kontaktieren des Halbleiterkörpers 3 nach dem Verlöten ermöglicht. Weiterhin ist es besonders vorteilhaft, wenn diese Verfahrensschritte in einer Schutzgasatmosphäre ablaufen. Dadurch wird sichergestellt, daß sich keine Oxidschicht auf der Lotoberfläche bildet.

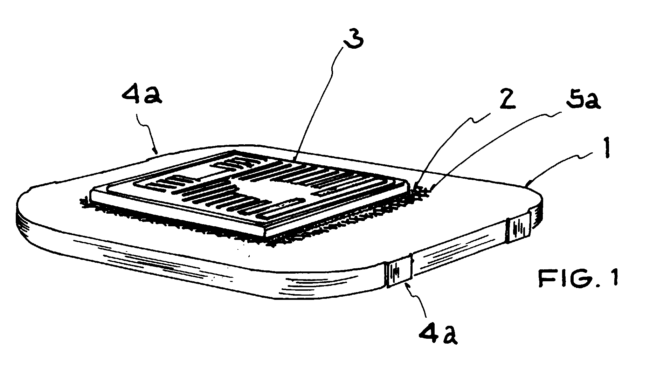

Beim sich anschließenden Prozeßschritt wird die oben beschriebene Anordnung in einem Lötofen auf eine Temperatur erhitzt, die über der Liquidustemperatur des Lotes liegt. Dabei schmilzt das Lot 2 auf, verläuft und verteilt sich gleichmäßig zwischen Träger 1 und Halbleiterkörper 3. Die Figur 1 zeigt ein nach dem erfindungsgemäßen Verfahren hergestelltes Bauelement.

Die Kanäle 8 der Riffelung 5 des Trägers 1 unterstützen das gleichmäßige Verlaufen des Lotes 2 und sorgen für eine zusätzliche Entlüftung möglicher Lufteinschlüsse. Der Lötprozeß findet vorteilhafterweise in einem Vakuumofen statt. Dadurch wird die Lunkerbildung durch Lufteinschlüsse vollständig unterbunden. Es kann vorteilhaft sein, wenn der Lötprozeß in einer reduzierenden Atmosphäre abläuft. In diesem Falle werden Oxidschichten auf der zu verlötenden Oberfläche reduziert und somit die Fluß- und Benetzungseigenschaften des Lotes verbessert. Benetzungs-, Kapillar- und Kohäsionskräfte sorgen dafür, daß das Lot nicht seitlich zwischen Halbleiterkörper 3 und Träger 1 herausläuft, sondern unter der Fläche des Halbleiterkörpers gehalten wird.

Das Auflegen des Halbleiterkörpers mittels einer Reibebewegung sorgt für die bis zur endgültigen Verlötung notwendige Stabilität der Anordnung.

Bei dem Verfahren nach der Erfindung wird der Halbleiterkörper 3 nicht, wie bei den Verfahren nach dem Stand der Technik üblich, in die Lotschmelze getaucht und diese zwischen dem Halbleiterkörper 3 und dem Träger 1 verdrängt, sondern es wird durch die spezielle Anordnung erreicht, daß das Lot 2 unter dem Halbleiterkörper 3 gehalten wird. Der seitliche Lotauslauf wird verhindert. Dadurch kann der Halbleiterkörper 3 nicht auf der flüssigen Lotschmelze verschwimmen.

Anstelle des Belegens des Trägers 1 mit einem Lotformteil, kann es auch vorgesehen sein, durch Abschmelzen von drahtförmigem Lot auf einem über die Schmelztemperatur des verwendeten Lots erwärmten Träger eine Lotschicht zu erzeugen. Dabei bildet sich eine linsenförmige Schicht aus. Anschließend wird der Träger mit der linsenförmigen Lotschicht auf die zweite Temperatur abgekühlt, die kleiner ist als der Soliduspunkt des verwendeten Lotes. Das sich anschließende Heften des Halbleiterkörpers mit der Reibebewegung und das Verlöten des Halbleiterkörpers mit dem Träger erfolgt in der oben beschriebenen Weise. Diese Abwandlung des erfindungsgemäßen Verfahrens hat zum Vorteil, daß keine speziellen Lotformteile vorgefertigt werden müssen und sich die Lotmenge je nach Bedarf verändern läßt, ohne Änderungen am Lotformteil vornehmen zu müssen.

Durch das Verfahren sind dicke, thermisch hochbelastbare Lotverbindungen erzielbar, die vollautomatisch hergestellt werden können. Es bietet sich an, die oben beschriebenen Verfahrensschritte in einer Verbundanordnung aus Lötofen und Vormontageeinheit auszuführen. Die vormontierten Trägerstreifen 1a gelangen sofort nach dem Auflegen von Lotformteil bzw. dem Aufschmelzen des Lotes und Halbleiterkörper direkt in den Lötofen, ohne daß eine Zwischenlagerung bei normalen Umgebungsbedingungen notwendig wird.

## Patentansprüche

1. Verfahren zum Auflöten eines scheibenförmigen Halbleiterkörpers (3) auf einen Träger (1), wobei der Träger (1) zunächst mit einem Lotformteil (2) versehen und anschließend mit dem Halbleiterkörper (3) belegt wird, dadurch gekennzeichnet, daß der Halbleiterkörper (3) vor dem Verlöten mit dem Träger (1) durch eine Reibebewegung mit einer senkrecht zu Verbindungsebene wirkenden Kraft auf das Lotformteil (2) aufgelegt und justiert wird, wobei eine punktuelle Verbindung zwischen Halbleiterkörper (3) und aufgelegtem Lotformteil (2) entsteht, und daß abschließend die so entstandene Anordnung in einem Ofenprozeß auf eine derartige Temperatur erhitzt wird, daß Halbleiterkörper (3) und Träger (1) miteinander verlötet werden.

2. Verfahren nach Anspruch 1, dadurch gekennzeichnet, daß das Lotformteil (2) bei einer ersten Temperatur auf den Träger (1) aufgelegt wird.

3. Verfahren nach Anspruch 2, dadurch gekennzeichnet, daß die erste Temperatur kleiner ist als der Liquiduspunkt des verwendeten Lotes.

4. Verfahren nach Anspruch 2 oder 3, dadurch gekennzeichnet, daß bei Verwendung eines nicht-eutektischen Lotes die erste Temperatur zwischen dem Solidus- und dem Liquiduspunkt des verwendeten Lotes liegt.

5. Verfahren nach einem der Ansprüche 1 bis 4, dadurch gekennzeichnet, daß das Lotformteil (2) nach dem Auflegen auf den Träger (1) mittels eines Flachstempels planiert wird.

6. Verfahren nach einem der Ansprüche 2 bis 5, dadurch gekennzeichnet, daß der Halbleiterkörper (3) bei einer zweiten Temperatur auf das Lotformteil (2) aufgelegt wird, die kleiner ist als die erste Temperatur.

7. Verfahren nach Anspruch 4, dadurch gekennzeichnet, daß der Halbleiterkörper (3) bei einer zweiten Temperatur auf das Lotformteil (2) aufgelegt wird, die kleiner ist als der Soliduspunkt des verwendeten Lotes.

8. Verfahren zum Auflöten eines scheibenförmigen Halbleiterkörpers (3) auf einen Träger (1), wobei der Träger (1) zunächst mit einer Lotlinse versehen und anschließend mit dem Halbleiterkörper (3) belegt wird, wobei die Lotlinse durch Abschmelzen von drahtförmigem Lot auf dem Träger erzeugt wird, dessen Temperatur über der Schmelztemperatur des verwendeten Lotes liegt, dadurch gekennzeichnet, daß der Träger vor dem Auflegen des Halbleiterkörpers (3) auf eine zweite Temperatur abgekühlt wird, die kleiner ist als der Soliduspunkt des verwendeten Lotes, und daß der Halbleiterkörper (3) vor dem Verlöten mit dem Träger (1) durch eine Reibebewegung mit einer senkrecht zur Verbindungsebene wirkenden Kraft auf die Lotlinse aufgelegt und justiert wird, wobei eine punktuelle Verbindung zwischen Halbleiterkörper (3) und der Lotlinse entsteht, und daß abschließend die so entstandene Anordnung in einem Ofenprozeß auf eine derartige Temperatur erhitzt wird, daß Halbleiterkörper (3) und Träger (1) miteinander verlötet werden.

9. Verfahren nach einem der Ansprüche 1 bis 8, dadurch gekennzeichnet, daß die bei der Reibebewegung auf den Halbleiterkörper (3) wirkende Auflagekraft zwischen 20 und 100 mN liegt.

10. Verfahren nach einem der Ansprüche 1 bis 9, dadurch gekennzeichnet, daß die Reibebewegung eine Frequenz von 5 bis 10 Hz aufweist.

11. Verfahren nach einem der Ansprüche 1 bis 10, dadurch gekennzeichnet, daß der Halbleiterkörper (3) bei der Reibebewegung eine maximale Amplitude von ca. 10 µm Auslenkung erfährt.

12. Verfahren nach einem der Ansprüche 1 bis 11, dadurch gekennzeichnet, daß die Verfahrensschritte des Auflegens des Lotformteils (2) bzw. des Abschmelzens der Lotlinse und des Aufreibens des Halbleiterkörpers (3) zur Vermeidung von Oxidation in einer Schutzgasatmosphäre ablaufen.

13. Verfahren nach einem der Ansprüche 1 bis 12, dadurch gekennzeichnet, daß der Verfahrensschritt des Verlötens des Halbleiterkörpers (3) mit dem Träger (1) in einem Vakuumofen abläuft.

14. Verfahren nach einem der Ansprüche 1 bis 12, dadurch gekennzeichnet, daß der Verfahrensschritt des Verlötens des Halbleiterkörpers (3) mit dem Träger (1) in einer reduzierenden Atmosphäre abläuft.

15. Verfahren nach einem der Ansprüche 1 bis 14, dadurch gekennzeichnet, daß die flächenmäßigen Abmessungen des Lotformteils (2) bzw. der Lotlinse gleich bzw. etwas kleiner sind als diejenigen des Halbleiterkörpers (3).

16. Verfahren nach einem der Ansprüche 1 bis 15, dadurch gekennzeichnet, daß der Träger (1) im Bereich, in dem der Halbleiterkörper (3) aufgelötet werden soll, eine Riffelung (5) aufweist.

17. Verfahren nach Anspruch 16, dadurch gekennzeichnet, daß die flächenmäßigen Abmessungen der Riffelung (5) des Trägers (1) gleich groß bzw. etwas größer sind als diejenigen des Halbleiterkörpers (3).

## Claims

1. A process for soldering a wafer-like semiconductor body (3) onto a carrier (1), where the carrier (1) is firstly provided with a solder preform (2) and then is covered with the semiconductor body (3), characterised in that prior to the soldering to the carrier (1) the semiconductor body (3) is applied to the solder preform (2) by a frictional movement with a force acting at right angles to the connection plane, and is adjusted, whereby a punctiform joint arises between the semiconductor body (3) and the applied solder preform (2), and that finally the arrangement thus formed is heated in an oven process to a temperature such that semiconductor body (3) and carrier (1) are soldered to one another.

2. A process according to Claim 1, characterised in that the solder preform (2) is applied to the carrier (1) at a first temperature.

3. A process according to Claim 2, characterised in that the first temperature is lower than the liquidus point of the solder used.

4. A process according to Claim 2 or 3, characterised in that when a non-eutectic solder is used, the first temperature is between the solidus point and the liquidus point of the solder used.

5. A process according to one of Claims 1 to 4, characterised in that following application to the carrier (1) the solder preform (2) is planed by means of a flat die.

6. A process according to one of Claims 2 to 5, characterised in that the semiconductor body (3) is applied to the solder preform (2) at a second temperature which is lower than the first temperature.

7. A process according to Claim 4, characterised in that the semiconductor body (3) is applied to the solder preform (2) at a second temperature which is lower than the solidus point of the solder used.

8. A process for soldering a wafer-like semiconductor body (3) onto a carrier (1), where the carrier (1) is firstly provided with a solder lens and is then covered with the semiconductor body (3), where the solder lens is produced by melting filamentary solder on the carrier, the temperature of which filamentary solder exceeds the melting temperature of the solder used, characterised in that prior to the application of the semiconductor body (3) the carrier is cooled to a second temperature which is lower than the solidus point of the solder used, and that prior to the soldering to the carrier (1) the semiconductor body (3) is applied to the solder lens by a frictional movement with a force acting at right angles to the connection plane, and is adjusted, whereby a punctiform joint arises between semiconductor body (3) and solder lens, and that finally the arrangement thus formed is heated in an oven process to a temperature such that semiconductor body (3) and carrier (1) are soldered to one another.

9. A process according to one of Claims 1 to 8, characterised in that the bearing force acting on the semiconductor body (3) during the frictional movement is between 20 and 100 mN.

10. A process according to one of Claims 1 to 9, characterised in that the frictional movement has a frequency of 5 to 10 Hz.

11. A process according to one of Claims 1 to 10, characterised in that the semiconductor body (3) experiences a maximum amplitude of deflection of approximately 10 µm during the frictional movement.

12. A process according to one of Claims 1 to 11, characterised in that the process steps of application of the solder preform (2) or melting of the solder lens and frictional application of the semiconductor body (3) take place in a protective gas atmosphere in order to avoid oxidation.

13. A process according to one of Claims 1 to 12, characterised in that the process step of soldering the semiconductor body (3) to the carrier (1) takes place in a vacuum oven.

14. A process according to one of Claims 1 to 12, characterised in that the process step of soldering the semiconductor body (3) to the carrier (1) takes place in a reducing atmosphere.

15. A process according to one of Claims 1 to 14, characterised in that the surface measurements of the solder preform (2) or solder lens are equal to or somewhat smaller than those of the semiconductor body (3).

16. A process according to one of Claims 1 to 15, characterised in that the carrier (1) has a corrugation (5) in the region in which the semiconductor body (3) is to be soldered-on.

17. A process according to Claim 16, characterised in that the surface measurements of the corrugation (5) of the carrier (1) are equal to or somewhat greater than those of the semiconductor body (3).

## Revendications

1. Procédé de soudage d'un substrat semiconducteur (3) sous forme de disque sur un support (1), le support (1) étant tout d'abord muni d'une pièce profilée de soudure (2) et ensuite équipé du substrat semiconducteur (3), caractérisé en ce que le substrat semiconducteur (3) avant la soudure avec le support (1) est posé et ajusté sur la pièce profilée de soudure (2) grâce à mouvement de frottement avec une force s'exerçant perpendiculairement au plan de la liaison, une liaison ponctuelle entre le substrat semiconducteur (3) et la pièce profilée de soudure (2) posée étant obtenue, et en ce qu'enfin le dispositif ainsi obtenu est chauffé dans un four de processus à une température telle que le substrat semiconducteur (3) et le support (1) sont soudés l'un à l'autre.

2. Procédé selon la revendication 1, caractérisé en ce que la pièce profilée de soudure (2) est posée sur le support (1) à une première température.

3. Procédé selon la revendication 2, caractérisé en ce que la première température est inférieure à la température de liquidus de la soudure utilisée.

4. Procédé selon la revendication 2 ou 3, caractérisé en ce que, dans le cas de l'utilisation d'une soudure non eutectique, la première température se trouve entre la température de solidus et de liquidus de la soudure utilisée.

5. Procédé selon l'une quelconque des revendications 1 à 4, caractérisé en ce que la pièce profilée de soudure (2) est aplanie après la pose sur le support (1) au moyen d'un poinçon plat.

6. Procédé selon l'une quelconque des revendications 2 à 5, caractérisé en ce que le substrat semiconducteur 3 est posé sur la pièce profilée de soudure (2) à une seconde température inférieure à la première température.

7. Procédé selon la revendication 4, caractérisé en ce que le substrat semiconducteur (3) est posé sur la pièce profilé de soudure (2) à une seconde température inférieure à la température de solidus de la température utilisée.

8. Procédé de soudage d'un substrat semiconducteur (3) sous forme de disque sur un support (1), le support (1) étant tout d'abord muni d'une lentille de soudure et ensuite revêtu du substrat semiconducteur (3), la lentille de soudure étant formée par fusion de soudure sous forme de fil sur le support, dont la température est supérieure à la température de fusion de la soudure utilisée, caractérisé en ce que le support avant la pose du substrat semiconducteur (3) est refroidi à une seconde température inférieure à la température de solidus de la soudure utilisée, et en ce que le substrat semiconducteur (3) avant le soudage avec le support (1) est posé et ajusté sur la lentille de soudure grâce à un mouvement de frottement avec une force s'exerçant perpendiculairement au plan de la liaison, une liaison ponctuelle entre le substrat semiconducteur (3) et la lentille de soudure étant obtenue et en ce qu'enfin le dispositif résultant est chauffé dans un four de processus à une température de telle sorte que le substrat semiconducteur (3) et le support (1) soient soudés l'un à l'autre.

9. Procédé selon l'une quelconque des revendications 1 à 8, caractérisé en ce que la force d'application s'exerçant lors du mouvement de frottement sur le substrat semiconducteur (3) est comprise entre 20 et 100 mN.

10. Procédé selon l'une quelconque des revendications 1 à 9, caractérisé en ce que le mouvement de frottement présente une fréquence de 5 à 10 Hz.

11. Procédé selon l'une quelconque des revendications 1 à 10, caractérisé en ce que le substrat semiconducteur (3) subit lors du mouvement de frottement une amplitude maximale de déviation d'environ 10 µm.

12. Procédé selon l'une quelconque des revendications 1 à 11, caractérisé en ce que les étapes de procédés de la pose de la pièce profilée de soudure (2) ou de la fusion de la lentille de soudure et du frottement du substrat semiconducteur (3) se déroulent en vue d'éviter une oxydation dans une atmosphère de gaz protectrice.

13. Procédé selon l'une quelconque des revendications 1 à 12, caractérisé en ce que l'étape de procédé de la soudure du substrat semiconducteur (3) au support (1) se déroule dans un four à vide.

14. Procédé selon l'une quelconque des revendications 1 à 12, caractérisé en ce que l'étape de procédé de la soudure du substrat semiconducteur (3) au support (1) se déroule dans une atmosphère réductrice.

15. Procédé selon l'une quelconque des revendications 1 à 14, caractérisé en ce que les dimensions superficielles de la pièce profilée de soudure (2) ou de la lentille de soudure sont identiques ou légèrement inférieures à celles du substrat semiconducteur (3).

16. Procédé selon l'une quelconque des revendications 1 à 15, caractérisé en ce que le support (1) présente un striage (5) dans la zone dans laquelle doit être soudé le substrat semiconducteur (3).

17. Procédé selon la revendication 16, caractérisé en ce que les dimensions superficielles du striage (5) du support (1) sont identiques ou légèrement supérieures à celles du substrat semiconducteur (3).
